# EUROPEAN PATENT APPLICATION

(11) **EP 4 535 956 A1**
(43) Date of publication of application: **09.04.2025**
(21) Application number: 24201845.5
(22) Date of filing: 23.09.2024
(51) Int. Cl.: H10D 30/47, H10D 30/01, H01L 23/29, H01L 23/31, H01L 21/56, H10D 64/20, H10D 62/17, H10D 64/23, H10D 62/85

(54) **HEMT TRANSISTOR**

(30) Priority: 05.10.2023 FR 2310687
(71) Applicant: STMicroelectronics International N.V., 1228 Plan-les-Ouates, Geneva (CH)
(72) Inventor: COLPANI, Paolo, 20864 AGRATE BRIANZA (IT); LIVELLARA, Luisito, 20063 CERNUSCO SUL NAVIGLIO (IT)
(74) Representative: Cabinet Beaumont

(57) **Abstract**

The present disclosure relates to an HEMT transistor comprising:
- a first semiconductor layer (13);
- a gate (15) arranged on a first surface of the first semiconductor layer (13);
- a first passivation layer (17) comprising at least a sub-layer of a first dielectric material on the sides of the gate, the first passivation layer further extending over a first portion of said surface of the first semiconductor layer; and
- a second passivation layer (19), distinct from the first passivation layer (19), comprising at least a sub-layer of the same first dielectric material on a second portion of said surface of the first semiconductor layer next to the first passivation layer.

## Description

### Technical field

The present disclosure generally concerns the field of transistors and more particularly the field of high electron mobility transistors also called HEMT.

### Background art

HEMT transistors rely on a heterojunction having a two-dimensional electron gas also called 2DEG forming at their surface.

There exists a need to improve HEMT transistors and their manufacturing methods.

### Summary of Invention

To achieve this, an embodiment provides:

An HEMT transistor comprising:
- a first semiconductor layer;
- a gate arranged on a first surface of the first semiconductor layer;
- a first passivation layer comprising at least a sub-layer made of a first dielectric material on the sides of the gate, the first passivation layer further extending over a first portion of said surface of the first semiconductor layer; and
- a second passivation layer, distinct from the first passivation layer, comprising at least a sub-layer made of the same first dielectric material on a second portion of said surface of the first semiconductor layer next to the first passivation layer.

According to an embodiment, the first dielectric material is aluminum nitride.

According to an embodiment, the first semiconductor layer is based on gallium nitride, for example made of aluminum-gallium nitride.

According to an embodiment, the transistor comprises a source contact metallization and a drain contact metallization, respectively arranged on either side of the gate.

According to an embodiment, the first passivation layer extends laterally from the gate towards the drain contact metallization, over a portion only of the surface between the gate and the drain contact metallization, the first passivation layer further extending laterally from the gate to the source contact metallization.

According to an embodiment, the second passivation layer extends laterally from an edge of the first passivation layer located between the gate and the drain contact metallization, to the drain contact metallization.

According to an embodiment, the first passivation layer is covered with an insulating layer, the second passivation layer covering the side of the insulating layer located between the gate and the drain contact metallization and extending over a portion of the insulating layer towards the gate.

According to an embodiment, the first passivation layer comprises a first sub-layer and a second sub-layer, the first sub-layer being made of the first dielectric material, the second sub-layer being made of a second dielectric material different from the first dielectric material and the second sub-layer covering the upper face of the first sub-layer.

According to an embodiment, the second dielectric material is alumina.

According to an embodiment, the first dielectric material of the first passivation layer and the first dielectric material of the second passivation layer have different physical properties.

Another embodiment provides a method of forming an HEMT transistor, comprising the following successive steps:
a) forming a first semiconductor layer;
b) forming a gate on a first surface of the first semiconductor layer;
c) forming :
   a first passivation layer comprising at least a sub-layer made of a first dielectric material on the sides of the gate, the first passivation layer further extending over a first portion of said surface of the first semiconductor layer, and a second passivation layer, distinct from the first passivation layer, comprising at least a sub-layer made of the same first dielectric material on a second portion of said surface of the first semiconductor layer next to the first passivation layer.

According to an embodiment, during step c), the first passivation layer is formed before the second passivation layer, the step c) comprising:
- a step of depositing the first passivation layer;
- a step of depositing an insulating layer;
- a step of partially etching the first passivation layer and the insulating layer; and
- a step of depositing the second passivation layer on the upper face of the first semiconductor layer and the insulating layer.

According to an embodiment:
the first passivation layer comprises a first sub-layer and a second sub-layer, the first sub-layer being made of the first dielectric material, the second sub-layer being made of a second dielectric material different from the first dielectric material and the second sub-layer covering the upper face of the first sub-layer, and step c) comprises:
- a step of depositing the first sub-layer;
- a step of deposition the second sub-layer ;
- a step of depositing an insulating layer;
- a step of partially etching the first passivation layer and the insulating layer; and
- a step of depositing the second passivation layer on the upper face of the first semiconductor layer and the insulating layer.

According to an embodiment, during step c), the first and the second passivation layers are coated during one deposition step, step c) being preceded by a step of locally thermal treatment.

According to an embodiment, step c) comprises successively a step of depositing the first passivation layer and a step of depositing the second passivation layer, the second passivation layer being deposited by a deposition process different from the deposition process for the first passivation layer.

### Brief description of drawings

The foregoing features and advantages, as well as others, will be described in detail in the following description of specific embodiments given by way of illustration and not limitation with reference to the accompanying drawings, in which:
Figure 1 is a partial simplified cross-section view of an example of an HEMT transistor according to a first embodiment;
Figure 2A, Figure 2B, Figure 2C, Figure 2D, Figure 2E, Figure 2F, Figure 2G, Figure 2H, Figure 2I and Figure 2J are cross-section views illustrating steps of an example of a method of manufacturing the HEMT transistor illustrated in Figure 1;
Figure 3 is a partial simplified cross-section view of an example of an HEMT transistor according to a second embodiment;
Figure 4 is a partial simplified cross-section view of an example of an HEMT transistor according to a third embodiment; and
Figure 5A, Figure 5B and Figure 5C are cross-section views illustrating steps of an example of a method of manufacturing the HEMT transistor illustrated in Figure 4.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, the applications that the described HEMT transistors may have are not detailed, the embodiments being compatible with usual applications of HEMT transistors. The field of HEMT transistors, capable of withstanding relatively high voltages in the off state, for example, voltages in the order of from 100 to 650 volts, is more particularly considered herein.

Unless indicated otherwise, when reference is made to two elements connected together, this signifies a direct electrical connection without any intermediate elements other than electrical conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

For the purposes of the present invention, the expression "same materials" means that two materials have a respective chemical composition (or stoichiometry) substantially containing the same main chemical elements (or components). The expression "main chemical element" means that the element has a stoichiometric percentage greater than 40% in the chemical composition. Typically, the stoichiometric percentage of each main chemical element in the two materials can be (nominally) different. For example, the real stoichiometric percentage of a main chemical element can vary in a range of +3%/-3%, preferably +2%/-2%, from the nominal value (e.g., in AlN the nominal stoichiometric percentage of both Al and N is 50%, while the actual stoichiometric percentage could range within 47%-53%). Moreover, two same materials can contain different traces of impurity elements (such as Carbon, Hydrogen and Oxygen). For the purposes of the present invention, "impurity element" means an element present in the chemical composition with a stoichiometric percentage less than or equal to 2%, preferably less than or equal to 1%. Typically, an overall stoichiometric percentage of impurity elements in the material is less than or equal 5%, preferably less than or equal to 3%.

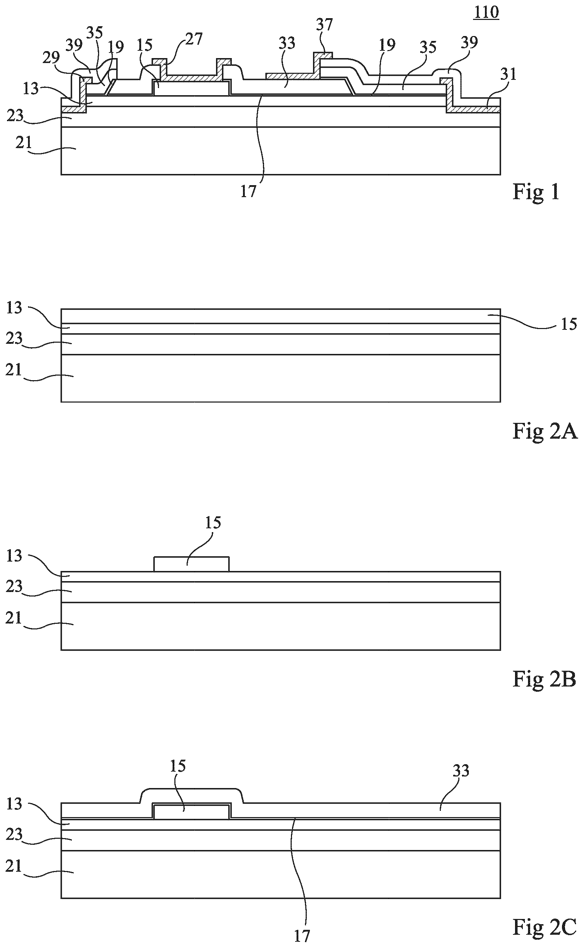

Figure 1 is a partial simplified cross-section view of an example of an HEMT transistor 110 according to an embodiment.

HEMT transistor 110 comprises a first semiconductor layer 13, arranged on a second conductive layer 23. Semiconductor layer 13 is for example in contact, by its lower surface, with the upper surface of conductive layer 23. As an example, the stack comprising semiconductor layer 13 and semiconductor layer 23 rests on a substrate 21. Semiconductor layer 23 is for example in contact, by its lower surface, with the upper surface of substrate 21. The interface between first semiconductor layer 13 and second semiconductor layer 23 defines a heterojunction at the surface of which a two-dimensional electron gas 2DEG also called electron channel is formed.

Semiconductor layers 13 and 23 are for example made of semiconductor materials of III-V type, for example, based on gallium nitride (GaN). Semiconductor layer 13 is for example made of aluminum-gallium nitride (AlGaN) . Semiconductor layer 23 is for example made of gallium nitride.

As an example, substrate 21 comprises a semiconductor material. Substrate 21 is for example made of silicon, or of silicon carbide. As a variant, substrate 21 is made of aluminum nitride. Substrate 21 for example comprises, on its upper surface side, a buffer layer, not detailed in the drawings, for example, made of gallium nitride. The buffer layer is for example in contact, by its upper surface, with the lower surface of semiconductor layer 23. Substrate 21 can be a complex composition of different semiconductor and isolation materials to guarantee good quality of layer 23. Substrate 21 can be silicon or different substrate (sapphire or SiC) plus a convenient sequence of AlN, AlGaN and GaN Layer to obtain appropriate layer 23 in terms of defects, stress, isolation with the semiconductor wafer.

HEMT transistor 110 comprises a gate 15 on the upper surface of semiconductor layer 13. Gate 15 is for example in contact, by its lower surface, with the upper surface of semiconductor layer 13.

Gate 15 is for example made of a semiconductor material, for example, of a III-V-type semiconductor material, for example made of gallium nitride, for example P-type doped.

As an example, HEMT transistor 110 further comprises a source contact metallization 29 and a drain contact metallization 31. As an example, contact metallizations 29 and 31 are based on titanium, titanium nitride, and/or on an alloy of aluminum and of copper. Source and drain contact metallizations 29 and 31 for example each define an ohmic contact with semiconductor layer 23 or with semiconductor layer 13. Contact metallizations 29 and 31 are for example located on top of and in contact with semiconductor layer 23, on either side of gate 15. Alternatively, contact metallizations 29 and 31 are for example located on top of and in contact with semiconductor layer 13, on either side of gate 15.

HEMT transistor 110 further comprises a first passivation layer 17 made of a first dielectric material, for example aluminum nitride, covering the sides of gate 15 and further extending over a portion of the upper surface of first semiconductor layer 13. In the example of Figure 1, passivation layer 17 also covers partially the upper surface of gate 15, in a peripheral part of gate 15 (near the sides of gate 15). As an example, passivation layer 17 is in contact, by its lower surface, with the upper surface of semiconductor layer 13. In the embodiment of Figure 1, passivation layer 17 covers a portion only of the upper surface of semiconductor layer 13, located next to gate 15, for example, at the periphery of gate 15. More particularly, in this example, passivation layer 17 extends laterally from gate 15 towards drain contact metallization 31, over a portion only of the surface between gate 15 and drain contact metallization 31. In other words, passivation layer 17 does not extend all the way to drain contact metallization 31. In this example, passivation layer 17 extends laterally from gate 15 towards source contact metallization 29, over a portion only of the surface between gate 15 and source contact metallization 29. In other words, passivation layer 17 does not extend all the way to source contact metallization 29. As a variation (not shown), passivation layer 17 extends laterally from gate 15 to source contact metallization 29.

HEMT transistor 110 further comprises a second passivation layer 19, distinct from the first passivation layer 17, made for example of the same first dielectric material of the first passivation layer 17, for example aluminum nitride.

Alternatively, the first and second passivation layer can be made of other nitride material or oxide material. In one alternative not shown embodiment the first and second passivation layer can be made of alumina, hafnium oxide, and/or nitrogen-based alumina.

For example, both the aluminum nitride of first passivation layer 17 and second passivation layer 19 have a chemical composition comprising a stoichiometric percentage of aluminum equal to 50% and a stoichiometric percentage of nitrogen equal to 50%.

Alternatively, the aluminum nitride of the first passivation layer and the aluminum nitride of the second passivation layer may have a chemical composition comprising a stoichiometric percentage of aluminum between 47% and 53% and a complementary stoichiometric percentage of nitrogen. For example, the chemical composition of the aluminum nitride of the first passivation layer is 47% of aluminum and 53% of nitride, and the chemical composition of the aluminum nitride of the second passivation layer is 51% of aluminum and 49% of nitride.

In one (not shown) embodiment, the chemical composition of one or both the aluminum nitride of the first and second passivation layers can contain a stoichiometric percentage of impurity element (e.g., hydrogen), for example equal to 1%.

Second passivation layer 19 is arranged on another portion of the upper surface of semiconductor layer 13. As an example, passivation layer 19 is in contact with the upper surface of first semiconductor layer 13. More precisely, passivation layer 19 is formed next to passivation layer 17 and covers a portion of semiconductor layer 13 which is not covered with passivation layer 17. Passivation layers 17 and 19 are for example in contact by their sides. In the shown example, passivation layer 19 extends laterally from the edge of passivation layer 17 located between gate 15 and drain contact metallization 31, all the way to drain contact metallization 31. In the shown example, passivation layer 19 also extends laterally from the edge of passivation layer 17 located between gate 15 and source contact metallization 29, all the way to source contact metallization 29, on top of and in contact with layer 13.

Passivation layers 17 and 19 for example each have a thickness in the range from 2 nm to 20 nm, for example in the range from 5 nm to 10 nm. Passivation layers 17 and 19 for example substantially have the same thickness. Alternatively, passivation layers 17 and 19 have different thicknesses based on application needs.

In a not shown embodiment, the gate is topped with an optional intermediate conductive layer made of a metallic material, for example, based on titanium nitride. The intermediate metal layer is for example in contact with the gate. The intermediate metal layer for example extends over a central portion only of the upper surface of the gate, so that a peripheral portion of the upper surface of the gate is not covered with metal layer. Passivation layer 17 for example extends laterally all the way to the intermediate metal layer. As a variant, the intermediate metal layer entirely covers the top surface of the gate.

Gate 15 is for example topped with a gate contact metallization 27 and is for example in direct contact therewith. As an example, gate contact metallization 27 is based on titanium nitride and/or on an alloy of aluminum and copper. When an intermediate metal layer (not shown) is present, gate contact metallization is for example in direct contact with the intermediate metal layer.

HEMT transistor 110 for example comprises a plurality of levels of insulating layers having metallizations formed inside and on top of them.

As an example, HEMT transistor 110 comprises a first insulating layer 33 on top of and in contact with the upper surface of passivation layer 17. As an example, insulating layer 33 covers the entire surface of passivation layer 17 and does not cover passivation layer 19. Insulating layer 33 is for example self-aligned with passivation layer 17. Insulating layer 33 is for example opened in front of a central portion of gate 15 to be crossed by gate contact metallization 27. Insulating layer 33 is for example made of a dielectric material, for example, of an oxide, for example, of silicon dioxide (SiO₂).

As an example, passivation layer 19 covers the side of insulating layer 33 located between gate 15 and drain contact metallization 31, and further extends over a portion of insulating layer 33 towards gate 15. Thus, starting from drain contact metallization 31, passivation layer 19 covers the portion of the upper surface of semiconductor layer 13 located between drain contact metallization 31 and passivation layer 17, then further extends over insulating layer 33, so that a portion of passivation layer 19 is in front of passivation layer 17 and separated therefrom by insulating layer 33. In the shown example, passivation layer 19 also covers the side of insulating layer 33 located between gate 15 and source contact metallization 29, and further extends over a portion of insulating layer 33 towards gate 15. Thus, starting from source contact metallization 29, passivation layer 19 covers the portion of the upper surface of semiconductor layer 13 located between source contact metallization 29 and passivation layer 17, then further extends over insulating layer 33, so that a portion of passivation layer 19 is in front of passivation layer 17 and separated therefrom by insulating layer 33. As an example, the insulating layer 19 is deposited and patterned self-aligned with insulating layer 35 (described below).

As an example, HEMT transistor 110 comprises a second insulating layer 35 on top of and in contact with the upper surface of passivation layer 19. As an example, insulating layer 35 has a side in contact with drain contact metallization 31 and extends towards source contact metallization 29. As an example, insulating layer 35 covers, for example exclusively, the entire surface of passivation layer 19. Insulating layer 35 thus for example extends over the portion of the upper surface of semiconductor layer 13 which is not covered by insulating layer 33 and over the peripheral portion of insulating layer 33. Insulating layer 35 is for example made of a dielectric material, for example, of silicon nitride (SiN) or of an oxide, for example of silicon dioxide (SiO₂).

For example, HEMT transistor 110 comprises a third insulating layer 39 covering the second insulating layer 35 and the source and drain contact metallizations 29 and 31. Third insulating layer 39 is for example made of the same material as insulating layers 33 and/or 35.

As an example, HEMT transistor 110 comprises a metal region 37 simultaneously extending over a portion of the surface of first insulating layer 33 not covered by the second insulating layer 35, and over a portion of the surface of the third insulating layer 39. Metal region 37 is thus arranged on two different insulating layer levels. As an example, metal region 37 is based on titanium nitride and/or on an alloy of aluminum and of copper. Metal region 37 is for example made of the same material as gate contact metallization 27.

Metal region 37 for example have the function of changing the profile of the electric field distribution of the drain-side edge of the gate (the right edge of the gate in Figure 1), and reducing the peak of the critical electric field, thereby increasing the avalanche voltage. For example, the metal region 37 is called field plate.

In the transistor of Figure 1, the 2DEG channel is for example normally off, that is, it is interrupted under gate 15, which prevents the flowing of a current between the source and the drain of the transistor. The transistor is then said to be in the off state. The channel may be restored (that is, made conductive) by the biasing of gate 15. In this case, a current may flow between the source and the drain of the transistor. The transistor is then said to be in the on or conductive state. The described embodiments may also apply to normally-on transistors.

The presence of passivation layers 17 and 19 allows the protection of the upper surface of semiconductor layer 13 on which dangling bonds and Ga-O bonds may be present introducing negative charges that can lead to a degradation of the 2 DEG mobility generating leakage currents and/or a decreasing the breakdown voltage of the transistor. Passivation layers 17 and 19 fill these bonds to make the surface of semiconductor layer 13 electrically inactive.

Passivation layers 17 and 19 also enable to protect semiconductor layer 13 against oxidation and to improve its state condition to which the 2DEG channel is sensitive.

Passivation layers 17 and 19 can reduce the interface state density and increase 2DEG carrier density and drift mobility through the suppression of trapping effect.

First passivation layer 17, and more particularly the portion of passivation layer 17 located on the sides of gate 15, enables to increase the resistivity of the 2DEG channel under and around the gate, which generates a decrease in the electric field formed at the corner of gate 15, and thus a decrease in leakage currents. On the other hand, the passivating effect of the part of layer 17 present on the sidewall of the gate is also important, always with the aim of reducing the leakage current (reducing conduction by traps mechanism at the side of gate 15).

Second passivation layer 19 enables to introduce positive charges at the interface between the passivation layer and first semiconductor layer 13, which locally increases the electron density in the 2DEG channel, and thus locally decreases the resistivity of the 2DEG channel and improve the value of R_{ON} on the device.

The use of the double passivation enables a compromise to be reached between leakage current reduction and resistivity reduction of the 2DEG channel.

In this embodiment, passivation layers 17 and 19 are both made of aluminum nitride but may be deposited under different deposition conditions to obtain the respective sought effects of locally increasing the resistivity of the 2DEG channel under and around the gate (passivation layer 17), and of locally increasing the electron density in the 2DEG channel (passivation layer 19). Alternatively, or in a complementary way, prior to depositing the passivation layers 17 and 19, the surface of semiconductor layer 13 may be subjected to different treatments with respect respectively to the area of deposition of the passivation layer 17 and to the area of deposition of the passivation layer 19, to obtain the respective sought effects of locally increasing the resistivity of the 2DEG channel (passivation layer 17), and of locally increasing the electron density in the 2DEG channel (passivation layer 19).

The first 17 and the second 19 passivation layers may have different physical structures. For example, the first passivation layer 17 and the second passivation layer 19 have different crystallographic properties. For example, the first passivation layer 17 and the second passivation layer 19 have different properties at the interface with the semiconductor layer 13.

As an example, usage of AlN material more similar to layer 13 (AlGaN) is able to restore the original characteristics of AlGaN layer restoring intrinsic 2DEG low resistivity damaged by processes needed to pattern and remove gate layer 15. In general, independently, it is possible to deposit the same material (layer 17 and 19) with different deposition condition to modulate the effect on gate leakage and 2DEG resistivity modulating impurity inside the film such as Carbon, Hydrogen and Oxygen or changing the film density to obtain layer with different permeability to H. This will protect by example the electrical performance of layer 15 used inside the gate.

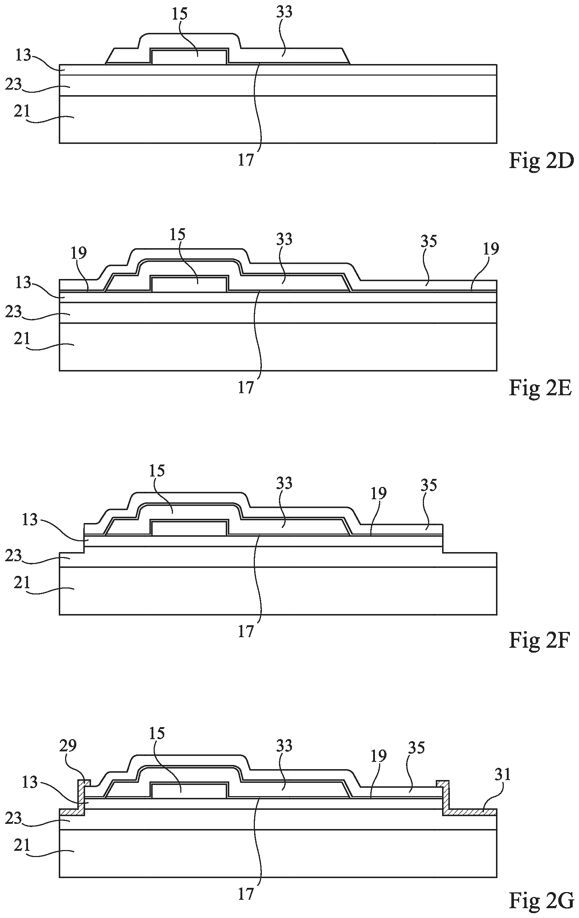

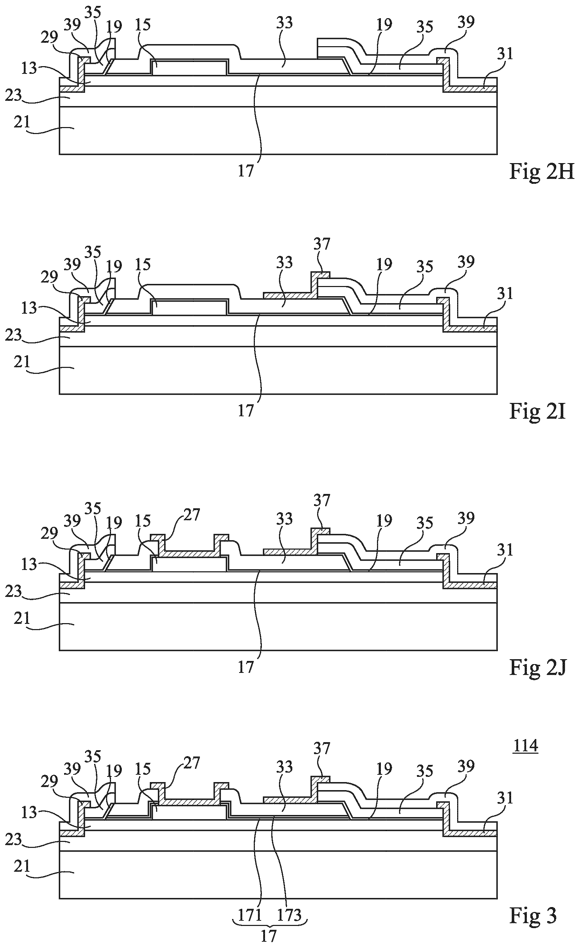

Figure 2A, Figure 2B, Figure 2C, Figure 2D, Figure 2E, Figure 2F, Figure 2G, Figure 2H, Figure 2I and Figure 2J are cross-section views illustrating successive steps of an example of a method of manufacturing the HEMT transistor illustrated in Figure 1.

Figure 2A illustrates an initial structure comprising, in the order, from the lower surface of the structure, substrate 21, second semiconductor layer, and first semiconductor layer 13. The initial structure further comprises a gate layer 15. In the initial structure illustrated in Figure 2A, layers 23, 13, and 15 extend continuously and with a substantially uniform thickness over the entire upper surface of substrate 21.

Figure 2B illustrates a structure obtained at the end of a step of local etching of gate layer 15 to only keep a portion of each layer forming the gate stack of the transistor of Figure 1.

During this step, gate 15 is etched for example by a plasma etching method, for example by a chlorine-based plasma etching method, for example, by a boron trichloride (BCl₃) and oxygen (O₂) plasma etching.

This etch steps is for example followed by a step of cleaning of the upper surface of the structure to remove for example residues originating from the etch mask(s) and impurities resulting from the etching of gate 15. The cleaning of the structure, for example, comprises a step of stripping by oxygen and nitrogen (N₂) plasma. The cleaning of the structure may further comprise a step of removal of organic residues by means of a solvent.

Figure 2C illustrates a structure obtained at the end of a step of forming passivation layer 17 and of insulating layer 33 on the upper surface of the structure illustrated in Figure 2B.

During this step, passivation layer 17 is first manufactured in continuous fashion, so that it covers the entire upper surface of the structure illustrated in Figure 2B.

Passivation layer 17 for example formed in contact with the upper surface of semiconductor layer 13, and the sides and the upper surface of the gate 15.

Passivation layer 17 is for example formed by a thin layer deposition method, for example, an Atomic Layer Deposition called also ALD method, for example by thermal or plasma using a convenient precursor of Al source. As an example, the method of deposition of passivation layer 17 is plasma-enhanced ALD or thermal-enhanced ALD. At the end of this step, passivation layer 17 has a thickness for example in the range from 1 nm to 15 nm, for example in the range from 3 nm to 10 nm, for example in the order of 6 nm.

Then, insulating layer 33 is, in this example, formed in continuous fashion, so that it covers the entire upper surface of passivation layer 17. Insulating layer 33 is for example formed in contact with passivation layer 17. Insulating layer 33 is for example formed by a plasma-enhanced chemical vapor deposition or PECVD or LPCVD or a different CVD technique. At the end of this step, insulating layer 33 has a thickness for example in the range from 10 nm to 200 nm, for example in the range from 30 nm to 150 nm, for example, in the order of 70 nm.

As an example, the steps of deposition of passivation layer 17 and of insulating layer 33 are preceded by one or a plurality of steps of preparation of the surface of the structure illustrated in Figure 2B. The preparation of the surface of the structure illustrated in Figure 2B may comprise a cleaning for example consisting of a chemical cleaning by means of acid, for example, hydrogen chloride (HCl) or hydrogen fluoride (HF) or by means of basic solutions, for example, ammonia (NH3). The preparation of the surface of the structure illustrated in Figure 2B may further comprise a cleaning for example consisting of a surface oxidation. Passivation layer 17 will thus be formed in contact with an oxide film, itself formed in contact with the upper surface of layer 13.

Figure 2D illustrates a structure obtained at the end of a step of etching of passivation layer 17 and of insulating layer 33.

More particularly, during this step, passivation layer 17 and insulating layer 33 are removed in front of a portion of semiconductor layer 13. As an example, layers 17 and 33 are kept next to gate 15, and removed outside of the periphery of gate 15, here in a portion located to the right and to the left of gate 15.

As an example, the removal of layers 17 and 33 is performed by plasma etching, for example, based on fluorine, for example, based on carbon tetrafluoride (CF₄).

The etching of layers 17 and 33 is, for example, selective and does not etch semiconductor layer 13. The etching of layers 17 and 33 then stops with the exposing of the upper surface of layer 13.

These etch steps are for example followed by a step of cleaning of the upper surface of the structure for example similarly to what has been described in relation with Figure 2B.

Figure 2E illustrates a structure obtained at the end of a step of forming of passivation layer 19 and of insulating layer 35 on the upper surface of the structure illustrated in Figure 2D.

During this step, passivation layer 19 is first formed in continuous fashion, so that it covers the entire upper surface of the structure illustrated in Figure 2D.

Passivation layer 19 is for example formed in contact with the upper surface of insulating layer 33 and the portion of semiconductor layer 13 which is not covered with passivation layer 17. As an example, passivation layer 19 further covers the etched side of layers 17 and 33.

Passivation layer 19 is for example formed by a thin layer deposition method, for example, an Atomic Layer Deposition (ALD method). As an example, the method of deposition of passivation layer 19 is a plasma-enhanced ALD or thermal ALD. At the end of this step, passivation layer 19 has a thickness for example in the range from 1 nm to 10 nm, for example in the range from 2 nm to 8 nm, for example in the order of 5 nm.

Then, insulating layer 35 is, in this example, formed in continuous fashion, so that it covers the entire upper surface of passivation layer 19. Insulating layer 35 is for example formed in contact with passivation layer 19. Insulating layer 35 is for example formed by a method similar to one of the possible methods of forming layer 33 described in relation with Figure 2C. At the end of this step, insulating layer 35 has a thickness for example in the range from 50 nm to 200 nm, for example in the order of 80 or 100 nm.

As an example, the steps of deposition of passivation layer 19 and of insulating layer 35 are preceded by one or a plurality of steps of preparation of the surface of the structure illustrated in Figure 2D similarly to what has been described in relation with Figure 2C.

Figure 2F illustrates a structure obtained at the end of a step of forming openings intended to receive the ohmic contacts and more particularly source and drain contact metallization 29 and 31.

Figure 2G illustrates a structure obtained at the end of a step of forming the ohmic contacts and more particularly source and drain contact metallizations 29 and 31.

Openings intended to receive source and drain contact metallizations 29 and 31 are, first, created in layers 35 and 19 (figure 2F). The openings are for example formed by a plasma etching method, for example, based on fluorine, for example, based on carbon tetrafluoride (CF₄). In this example, the etching extends through semiconductor layer 13 and emerges on or in semiconductor layer 23. The step of forming of the openings intended to receive contact metallizations 29 and 31 is for example followed by a step of cleaning of the upper surface of the structure, for example, similarly to what has been described in relation to Figure 2B.

As an example, a step of preparation of the surface of the upper side of layer 23 in the openings may be provided. This step for example comprises a chemical cleaning by means of acid, for example hydrogen chloride (HCl).

Then (figure 2G), source and drain contact metallizations 29 and 31 are for example formed in the previously formed openings. Metallizations 29, 31 are for example formed by deposition of one or a plurality of layers of a metallic material followed by an etch step.

In the shown example, source and drain metallizations extend at the bottom and on the sides of the openings, and also extend on top of passivation layer 35 next to the sides of the openings.

Figure 2H illustrates a structure obtained at the end of a step of forming of insulating layer 39 on the upper surface of the structure illustrated in Figure 2G, followed by a step of formin an opening in layers 39, 35 and 19 in a central part of the structure.

Insulating layer 39 is for example first formed in continuous fashion, so that it covers the entire upper surface of the structure illustrated in Figure 2G. Insulating layer 39 is for example formed by a method identical to the method of forming layer 33 described in relation to Figure 2C. At the end of this step, insulating layer 39 has a thickness for example in the range from 150 nm to 400 nm, for example in the range from 200 nm to 350 nm, for example, in the order of 300 nm.

A opening is then formed in a central part of the structure, the opening crossing vertically layers 39, 35 and 19 and emerging on the upper surface of layer 33. The opening extends in front of gate 15 and extends in front of a part of the area located between the gate 15 and the drain contact metallization 31.

Figure 2I illustrates a structure obtained at the end of a step of forming metallization 37 on the upper surface of the structure illustrated in Figure 2H.

As an example, during this step, region 37 is formed on a portion of the surface of the first insulating layer 33, and extends on one side of the opening formed at the step of figure 2H, and over the top of insulating layer 39 next to the side of the opening. Region 37 is for example formed by deposition of one or a plurality of layers made of a metallic material followed by an etch step.

Figure 2J illustrates a structure obtained at the end of a step of opening of layers 33 and 17 in front of the gate 15 of the structure illustrated in Figure 2I, and of a subsequent step of forming gate metallization 27 in the opening.

More particularly, during this step, layers 33 and 17 are removed in front of a central portion of the upper surface of gate 15.

As an example, the removal of layers 33 and 17 is performed by plasma etching, for example, based on fluorine, for example, based on carbon tetrafluoride (CF₄) or equivalent chemistry able to etch dielectric made by Silicon dioxide or Silicon nitride.

The presence of layer 17 and 19 below layer 33 and 35 is also useful from integration point of view because is possible to have etching steps able to stop on layer 17 and 19 before reaching respectively layer 15 and 13. In this way the impact on thickness and surface quality of layer 13 and 15 is preserved to maintain their electrical performances. The layer 17 and 19 removal can be executed in a gentle manner using wet etch chemistries or soft dry etching processes able to preserve layer 17 and 19 characteristics (thickness, surface quality).

The etching step of Figure 2J is for example selective or partially selective over layer 17, which can then be removed by wet process or soft dry etching. The partial removal of layers 33 and 17 is for example followed by a step of cleaning of the upper surface of the structure, for example similarly to what has been described in relation to Figure 2B.

Gate contact metallization 27 is formed in the opening formed in layers 33 and 17in front of the central portion of gate 15. As an example, gate contact metallization 27 is formed on top of and in contact with gate layer 15 or with an intermediate metal layer (not shown) covering the gate layer. Gate contact metallization 27 is for example formed by deposition of one or a plurality of layers made of a metallic material followed by an etch step.

As an example, the step of forming gate contact metallization 27 is preceded by a step of preparation of the surface of the structure, for example consisting of a chemical cleaning by means of acid, for example, hydrogen chloride (HCl) .

Figure 3 is a partial simplified cross-section view of an example of an HEMT transistor 114 according to a third embodiment.

Figure 3 illustrates a transistor 114 similar to the transistor 110 illustrated in relation to Figure 1, with the difference that the passivation layer 17 corresponds to a stack of a first sub-layer 171 made of a first dielectric material, preferably aluminum nitride, and a second sub-layer 173 made of a second dielectric material different from the first material, preferably alumina (Al₂O₃). The second passivation layer 19 is made of either the first or the second dielectric material. Preferably, the second passivation layer 19 is made of aluminum nitride.

In this embodiment, the first-sub layer 171 and the second sub-layer 173 are in contact with one another, the second sub-layer 173 coating the upper face of the first-sub layer 171.

The manufacturing process for the transistor 114 is, for example, similar to what has been described for transistor 110 in relation to Figures 2A to 2J. The first 171 and second sub layers 173 are manufactured in continuous fashion, so that they cover the upper surface of semiconductor layer 13, and the sides and the upper surface of the gate 15. Then, insulating layer 33 is, for example, formed in continuous fashion, so that it covers the entire upper surface of passivation layer 17. Then, the passivation layer 17 (formed by the two-sub-layers) and the insulating layer 33 are removed as explained above with reference to figure 2D.

As a variation (not shown), the second passivation layer corresponds to a part of the first sub-layer above which the second sub-layer has been removed. In that case, the second passivation layer does not overlap with the first insulating layer. The manufacturing process for such a transistor is, for example, similar to what has been described for transistor 110 in relation to Figures 2A to 2J, except that the etching step of Figure 2D stops on the upper surface of the first-sub layer. The first sub-layer is therefore not removed and continously propagates up to drain contact metallization. In other words, the second passivation layer is formed by the first-sub layer. In this embodiment, the step of depositing the second passivation layer as disclosed with reference elation to Figure 2E is not performed.

For example, the second sub-layer 173 is made of alumina (Al₂O₃).

As a variation, sub-layer 171 is made of alumina (AI₂O₃) and sub-layer 173 is made of AlN with different deposition conditions.

The addition of sub-layer 173 to passivation layer 17 advantageously modifies the passivation properties of passivation layer 17 with respect to the passivation properties of passivation layer 19, further increasing the resistivity of the 2DEG channel under and around the gate, while maintaining the low resistivity of the rest of the 2DEG channel.

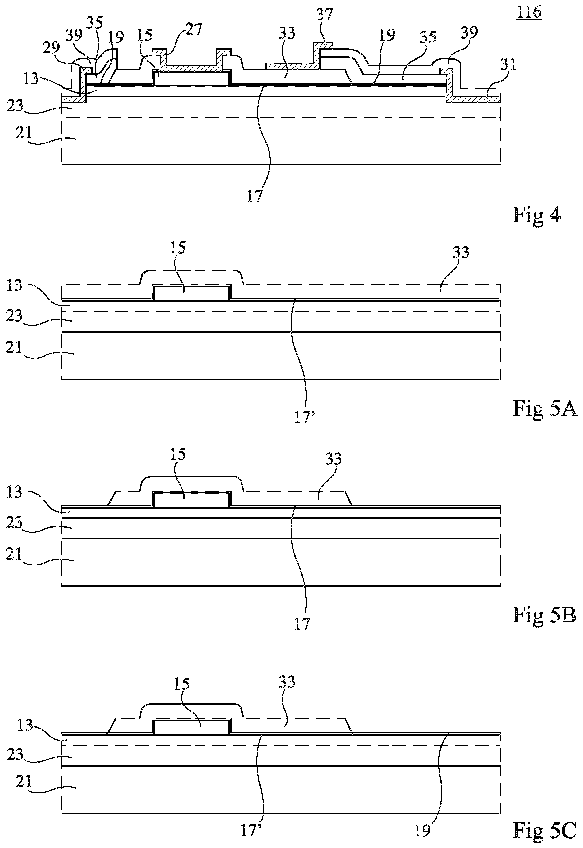

Figure 4 is a partial simplified cross-section view of an example of an HEMT transistor 116 according to a fourth embodiment.

Figure 4 illustrates a transistor 116 similar to the transistor 110 illustrated in relation to Figure 1, with the difference that the passivation layer 19 doesn't extend over the flanks and part of the upper face of the layer 33. In other words, the second passivation layer 19 is formed by a portion of the first passivation layer that (continously) extends in up to drain contact metallization 31. In this embodiment, the first 17 and second passivation layer 19 are in single piece (the division line between passivation layers 17 and 19 in figures 4 and 5C serves for illustrative purposes only).

For example, passivation layer 17 is made of alumina and passivation layer 19 is made of AlN.

Figure 5A, Figure 5B and Figure 5C are cross-section views illustrating steps of an example of a method of manufacturing the HEMT transistor 116 illustrated in Figure 4.

The process for manufacturing the transistor 116 illustrated in figure 4 includes, for example, steps similar to those illustrated in figures 2A to 2C with the difference that the passivation layer 17 is made of alumina. Starting with the formation of layers 17 and 33, as shown in connection with Figure 2C and reproduced in Figure 5A, in this embodiment, part of the alumina layer 17 is converted by chemical reaction into the aluminum nitride layer forming the passivation layer 19.

Figure 5B illustrates a structure obtained after a step of etching the insulating layer 33 of the structure illustrated in Figure 5A. In contrast to the step illustrated in figure 2D for the manufacture of transistor 110, in Figure 5B the etching of layer 33 is stopped on the upper surface of layer 17, so as to leave layer 17 even outside the plumb line of layer 33.

Figure 5C illustrates a step for transforming the part of the alumina passivation layer 17 not covered by layer 33 into aluminum nitride to form passivation layer 19.

For example, the transforming step is made by annealing the structure illustrated in figure 5B under ammonia. During this step, oxygen is degassed from layer 19 and replaced by nitrogen.

Alternatively, the transforming step is made by a nitride layer deposition on the top face of the structure at the end of the step illustrated in relation with Figure 5B, so as to cover the top face of passivation layer 17 and insulating layer 33, before a heating treatment applied to the entire structure.

At the end of this step, the manufacturing process for transistor 116 is, for example, identical to that described in relation with Figures 2E to 2J, except that a passivation layer 19 is not deposited during the step illustrated in Figure 2E.

In the embodiment shown in Figure 4 and Figures 5A to 5C, the use of two passivation layers 17 and 19 of different chemical natures between the gate and drain of the transistor advantageously improves the compromise between the transistor's on-state resistance and off-state leakage currents, with a single deposit of passivation material.

To achieve this, an embodiment provides a method of forming an HEMT transistor, comprising the following successive steps:
a) forming a first semiconductor layer 13;
b) forming a gate 15 on a first surface of the first semiconductor layer 13;
c) deposing a first dielectric material on the sides of the gate 15 and over the said surface of the first semiconductor layer 13;
d) forming an insulating layer 33 over a first portion of said first dielectric material, located on the sides of the gate 15 and in the vicinity of the grid ;
e) treating the first dielectric material, in a second portion next to the first portion, to transform the first dielectric material into a second dielectric material.

According to an embodiment, the first dielectric material is alumina.

According to an embodiment, the second dielectric material is aluminum nitride.

According to an embodiment, the first semiconductor layer 13 is based on gallium nitride, for example made of aluminum-gallium nitride.

According to an embodiment, the first semiconductor layer 13 is in contact, by a second surface opposite to the first surface, with a second semiconductor layer 23.

According to an embodiment, the second semiconductor layer 23 is made of gallium nitride.

According to an embodiment, the method comprises the formation of a source contact metallization 29 and a drain contact metallization 31.

According to an embodiment, the step e) comprises an annealing under ammonia.

According to an embodiment, the step e) comprises a step of forming a nitride layer on top the insulating layer followed by a step of heating treatment.

Various embodiments and variants have been described. Those skilled in the art will understand that certain features of these embodiments can be combined and other variants will readily occur to those skilled in the art.

In particular, it may be provided for the ohmic contact metallizations, for example, the source and drain contact metallizations, to be formed before the forming of the gate contact metallization.

Further, although the first embodiment has been described with an aluminum nitride passivation layer 17, the passivation layer 17 may be made of a first sub-layer made of aluminum nitride and of a second sub-layer, for example made of alumina, the first and the second sub-layers being in contact with each other and the first sub-layer of aluminum nitride coating the upper face of the second sub-layer. In this variant, the etching step illustrated in figure 2D comprises the etching of layer 33 and the etching of the stack of first and second sub-layers in order to uncover a part of the top surface of semiconductor layer 13 for subsequent deposition of passivation layer 19 and insulating layer 33.

Further, although an example of embodiment where the transistor gate 15 is in contact with the upper surface of upper semiconductor layer 13 has been described hereabove, as a variant, gate 15 may be separated from semiconductor layer 13 by a gate insulator layer.

Finally, the practical implementation of the embodiments and variants described herein is within the capabilities of those skilled in the art based on the functional description provided hereinabove.

## Claims

1. HEMT transistor comprising:
- a first semiconductor layer (13);
- a gate (15) arranged on a first surface of the first semiconductor layer (13);
- a first passivation layer (17) comprising at least a sub-layer made of a first dielectric material on the sides of the gate, the first passivation layer further extending over a first portion of said surface of the first semiconductor layer (13); and
- a second passivation layer (19), distinct from the first passivation layer (17), comprising at least a sub-layer made of the same first dielectric material on a second portion of said surface of the first semiconductor layer (13) next to the first passivation layer.

2. Transistor according to claim 1, wherein the first dielectric material is aluminum nitride.

3. Transistor according to claim 1 or 2, wherein the first semiconductor layer (13) is based on gallium nitride, for example made of aluminum-gallium nitride.

4. Transistor according to any of claims 1 to 3, comprising a source contact metallization (29) and a drain contact metallization (31), respectively arranged on either side of the gate (15).

5. Transistor according to claim 4, wherein the first passivation layer (17) extends laterally from the gate (15) towards the drain contact metallization (31), over a portion only of the surface between the gate (15) and the drain contact metallization (31), the first passivation layer (17) further extending laterally from the gate (15) to the source contact metallization (29).

6. Transistor according to any of claims 4 or 5, wherein the second passivation layer (19) extends laterally from an edge of the first passivation layer (17) located between the gate (15) and the drain contact metallization (31), to the drain contact metallization (31).

7. Transistor according to any of claims 1 to 6, wherein the first passivation layer (17) is covered with an insulating layer (33), the second passivation layer (19) covering the side of the insulating layer (33) located between the gate (15) and the drain contact metallization (31) and extending over a portion of the insulating layer (33) towards the gate (15).

8. Transistor according to any of claims 1 to 7, wherein the first passivation layer (17) comprises a first sub-layer (171) and a second sub-layer (173), the first sub-layer (171) being made of the first dielectric material, the second sub-layer (173) being made of a second dielectric material different from the first dielectric material and the second sub-layer (173) covering the upper face of the first sub-layer (171).

9. Transistor according to claim 8, wherein the second dielectric material is alumina.

10. Method of forming an HEMT transistor, comprising the following successive steps:
a) forming a first semiconductor layer (13);
b) forming a gate (15) on a first surface of the first semiconductor layer (13);
c) forming :
a first passivation layer (17) comprising at least a sub-layer made of a first dielectric material on the sides of the gate, the first passivation layer further extending over a first portion of said surface of the first semiconductor layer (13), and
a second passivation layer (19), distinct from the first passivation layer (19), comprising at least a sub-layer made of the same first dielectric material on a second portion of said surface of the first semiconductor layer next to the first passivation layer.

11. Method according to claim 10, wherein during step c), the first passivation layer (17) is formed before the second passivation layer (19), the step c) comprising :
- a step of depositing the first passivation layer (17);
- a step of depositing an insulating layer (33);
- a step of partially etching the first passivation layer (17) and the insulating layer (33); and
- a step of depositing the second passivation layer (19) on the upper face of the first semiconductor layer (13) and the insulating layer (33).

12. Method according to claim 10, wherein:
the first passivation layer (17) comprises a first sub-layer (171) and a second sub-layer (173), the first sub-layer (171) being made of the first dielectric material,
the second sub-layer (173) being made of a second dielectric material different from the first dielectric material and the second sub-layer (173) covering the upper face of the first sub-layer (171), and step c) comprises:
- a step of depositing the first sub-layer (171);
- a step of deposition the second sub-layer (173) ;
- a step of depositing an insulating layer (33);
- a step of partially etching the first passivation layer (17) and the insulating layer (33); and
- a step of depositing the second passivation layer (19) on the upper face of the first semiconductor layer (13) and the insulating layer (33).

13. Method according to claim 10, wherein during step c), the first (17) and the second (19) passivation layers are coated during one deposition step, step c) being preceded by a step of locally thermal treatment.

14. Method according to claim 10, wherein step c) comprises successively a step of depositing the first passivation layer (17) and a step of depositing the second passivation layer (19), the second passivation layer (19) being deposited by a deposition process different from the deposition process for the first passivation layer (17).
